# FASCICULE DE BREVET EUROPEEN

(11) **EP 0 863 512 B1**
(45) Date de publication et mention de la délivrance du brevet: **05.12.2001**
(21) Numéro de dépôt: 98201225.4
(22) Date de dépôt: 08.07.1994
(51) Int. Cl.: G11C 8/00, H03K 23/54, H03K 19/003, G11C 19/00

(54) **Mémoire à double accès**
Doppelzugriffspeicher
Dual-port memory

(30) Priorité: 12.07.1993 FR 9308837
(43) Date de publication de la demande: 09.09.1998
(62) Demande divisionnaire de: 94410047.8
(73) Titulaire: STMicroelectronics S.A., 94250 Gentilly (FR)
(72) Inventeur: Artieri, Alain, c/o SGS-THOMSON MICROELECTRO. S.A., 38926 Crolles (FR)
(74) Mandataire: de Beaumont, Michel

(56) Documents cités:
- EP-A- 0 390 453
- US-A- 4 864 543
- SAKAUE ETA L: "A 0.8um BiCMOS ATM switch on the 800Mbps asynchronous buffered banyan network" 1990 SYMPOSIUM ON VLSI CIRCUITS DIGEST OF TECHNICAL PAPERS, 7 juin 1990, HONOLULU, US, pages 65-66, XP000145610
- KAWAUCHI ET AL: "A 1.0um compilable FIFO buffer for standard cell" PROCEEDINGS OF THE IEEE 1989 CUSTOM INTEGRATED CIRCUITS CONFERENCE, 15 mai 1989, SAN DIEGO, US, pages 23.4.1-23.4.4, XP000075580

## Description

La présente invention concerne les mémoires à double accès, c'est-à-dire qui comprennent une entrée et une sortie distinctes, et plus particulièrement les mémoires de type premier-entré/premier-sorti (FIFO).

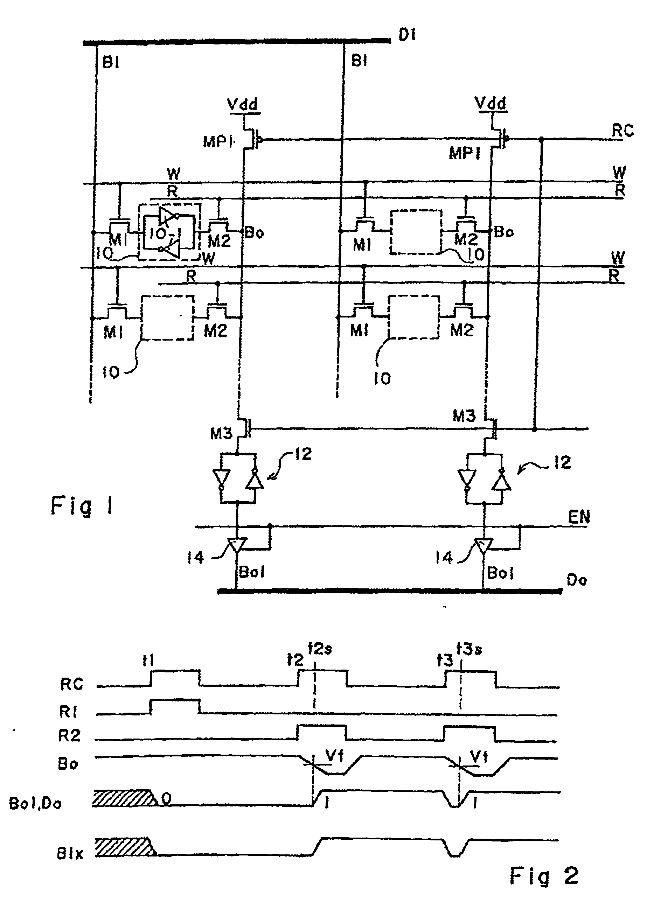

La figure 1 représente partiellement une structure de mémoire double accès classique. Cette mémoire comprend des cellules mémoire à double accès 10 disposées par colonnes. Comme cela est représenté, chaque cellule 10 comprend, par exemple, deux inverseurs 10-1 disposés tête-bêche. Chaque inverseur comprend une paire de transistors de sortie complémentaires (MOS à canaux N et P). L'entrée et la sortie de la cellule correspondent respectivement à l'entrée et à la sortie d'un premier des inverseurs. Le deuxième inverseur, dont la sortie est reliée à l'entrée de la cellule mémoire, comprend des transistors de sortie plus résistifs que ceux du premier inverseur, ce qui limite la consommation de courant lors d'une écriture dans la cellule.

A chaque colonne de cellules est associée une ligne d'entrée Bi et une ligne de sortie Bo. L'entrée de chaque cellule 10 d'une colonne est reliée à la ligne d'entrée correspondante Bi par un transistor MOS à canal N M1. La sortie de chaque cellule 10 d'une colonne est reliée à la ligne de sortie Bo correspondante par un transistor MOS à canal N M2. Les grilles des transistors M1 d'une même rangée de cellules sont reliées à une ligne d'écriture W et les grilles des transistors M2 d'une même rangée de cellules sont reliées à une ligne de lecture R.

Chaque ligne de sortie Bo est reliée à un potentiel d'alimentation haut Vdd par un transistor MOS à canal P MP1, dit transistor de précharge. Chaque ligne de sortie Bo est reliée à une sortie Bol de la mémoire par successivement un transistor MOS à canal N M3, un verrou 12 constitué d'inverseurs disposés tête-bêche, et une porte trois états 14.

Les transistors MP1 et M3 sont commandés par un signal RC de lecture de colonne. Les portes trois états 14 sont commandées par un signal de validation EN qui, selon le cas, est égal au signal RC ou fixé par un dispositif externe, tel qu'un microprocesseur, qui lit la mémoire. Les transistors de précharge MP1 peuvent aussi être à canal N ; dans ce cas ils sont commandés par l'inverse logique du signal RC.

Dans une configuration classique courante, les lignes d'entrée Bi sont reliées directement, ou par l'intermédiaire d'amplificateurs suiveurs non représentés, à des lignes respectives d'un bus de données d'entrée Di. Les sorties Bol de la mémoire sont reliées aux lignes respectives d'un bus de sortie Do. Ainsi, à des bus de données Di et Do de n lignes, on associe des mémoires à double accès de n colonnes.

Les lignes d'écriture W et de lecture R sont commandées par un décodeur d'adresses non représenté. Pour écrire dans la mémoire, un dispositif gérant le bus d'entrée Di présente une donnée sur le bus Di, émet une adresse (sur un bus d'adresses non représenté) qui sélectionne l'une des rangées de cellules, et active une ligne d'écriture de colonne WC (non représentée à la figure 1).

Pour lire dans la mémoire, un dispositif qui gère le bus Do émet une adresse qui sélectionne l'une des rangées de cellules, active la ligne RC de lecture de colonne, et valide la ligne EN.

Les mémoires à double accès du type de la figure 1 sont souvent utilisées dans des mémoires de type premier-entré/premier-sorti (FIFO). Une mémoire FIFO ne comprend pas de bus d'adresses. Pour lire dans une mémoire FIFO, on active la ligne RC de lecture de colonne et on récupère la donnée que la mémoire présente alors sur sa sortie (Bol). Pour écrire dans la mémoire FIFO, on active la ligne WC d'écriture de colonne en présentant une donnée à son entrée (Bi).

Une mémoire FIFO comprend généralement une mémoire à double accès du type de la figure 1 avec son décodeur d'adresses, les adresses étant fournies par un circuit de commande, relativement complexe, qui gère le mécanisme du "premier-entré/premier-sorti" en fonction des signaux de lecture WC et d'écriture RC de colonne, fournis de l'extérieur.

La figure 2 représente l'allure de divers signaux de la structure de la figure 1 lors de la lecture successive d'un "0" dans une première cellule et de deux fois un "1" dans une deuxième cellule. A des instants t1, t2 et t3 successifs, on décide d'effectuer les lectures susmentionnées.

A l'instant t1, on active la ligne de lecture de colonne RC et une ligne R1 qui correspond à l'une des lignes de lecture R. Le transistor MP2 est rendu passant et transmet la sortie de la cellule 10 sur la ligne de sortie Bo. Le transistor MP1 est bloqué et la ligne Bo n'est pas forcée au potentiel Vdd. La cellule 10 lue stocke un "0", ce qui veut dire que l'entrée de la cellule est à "0" alors que sa sortie est à "1". Ainsi, la ligne Bo reste à "1". Le transistor M3 est rendu passant et transmet l'état "1" de la ligne Bo sur l'entrée du verrou 12 qui inverse cet état. Ainsi, la sortie Bol, et la ligne correspondante du bus Do, passent ou restent à "0". Les lignes RC et R1 sont désactivées avant l'instant t2, ce qui rend conducteurs les transistors de précharge MP1 et bloque les transistors de sortie M3.

A l'instant t2, on décide de lire un "1" dans une deuxième cellule mémoire. La ligne RC est de nouveau activée et l'on active une ligne R2 correspondant à une autre ligne de lecture R. Cette fois-ci, la sortie de la cellule 10 lue est à "0". La ligne Bo passe lentement de Vdd à 0 en se déchargeant vers la sortie de la cellule 10 par le transistor M2, la sortie de la cellule 10 étant forcée à la masse par un transistor de la cellule. Le verrou 12 ne bascule que quand l'état de la ligne Bo atteint un seuil de basculement Vt à un instant t2s. Ainsi, la sortie Bol passe à "1" avec un certain retard par rapport à l'instant t2. Avant l'instant t3, les lignes RC et R2 sont désactivées, ce qui entraîne la remise à "1" des lignes de sortie Bo.

A l'instant t3, on lit la même cellule qu'à l'instant t2. Les lignes RC et R2 sont de nouveau activées. Comme à l'instant t2, la ligne Bo passe progressivement de Vdd à 0 en se déchargeant par le transistor M2 vers la sortie de la cellule lue. Toutefois, entre l'instant t3 et l'instant t3s où l'état de la ligne Bo atteint la tension seuil Vt, le verrou 12, dont l'entrée était à 0, bascule à l'instant t3, et bascule de nouveau à l'instant t3s. Ceci entraîne, comme cela est représenté, un passage intempestif à "0" de la sortie Bol entre les instants t3 et t3s.

On a également représenté, sous la référence Biₓ, l'allure d'une ligne d'entrée d'une deuxième mémoire à double accès dont l'entrée serait reliée au bus Do. L'état de cette ligne Bix varie de la même manière que la sortie correspondante Bol.

Une mémoire du type de la figure 1, comme tout circuit CMOS, ne consomme du courant que lors des transitions des signaux qui y transitent. Ainsi, la consommation d'une telle mémoire est indûment augmentée du fait des passages à "0" intempestifs de la sortie Dol entre deux lectures d'un "1". La consommation est en outre d'autant plus grande que les lignes sur lesquelles transitent ces signaux sont longues. Ainsi, la consommation devient particulièrement importante si la sortie d'une première mémoire à double accès est reliée aux entrées de plusieurs autres mémoires à double accès.

Un objet de la présente invention est de prévoir une structure de mémoire à double accès présentant une consommation particulièrement faible.

Un autre objet de la présente invention est de prévoir une mémoire FIFO à consommation particulièrement faible et de structure particulièrement simple.

Ces objets sont atteints grâce à une mémoire du type premier-entré/premier-sorti telle que définie dans la revendication 1. Des modes de réalisation avantageux sont définis dans les revendications dépendantes.

Le document US-A-4864543 décrit une mémoire de type premier-entré/premier-sorti comportant les caractéristiques du préambule de la revendication 1.

Ces objets, caractéristiques et avantages ainsi que d'autres de la présente invention seront exposés en détail dans la description suivante de modes de réalisation particuliers faite en relation avec les figures jointes parmi lesquelles :
la figure 1, précédemment décrite, représente partiellement une structure de mémoire à double accès classique ;
la figure 2 représente l'allure de divers signaux de la mémoire de la figure 1 lors de cycles de lecture ;
la figure 3 représente un mode de réalisation selon la présente invention d'un circuit de commande des lignes de lecture et d'écriture d'une mémoire FIFO ; et
la figure 4 représente un exemple de circuit permettant de générer des signaux d'état d'une mémoire FIFO munie du circuit de commande de la figure 3.

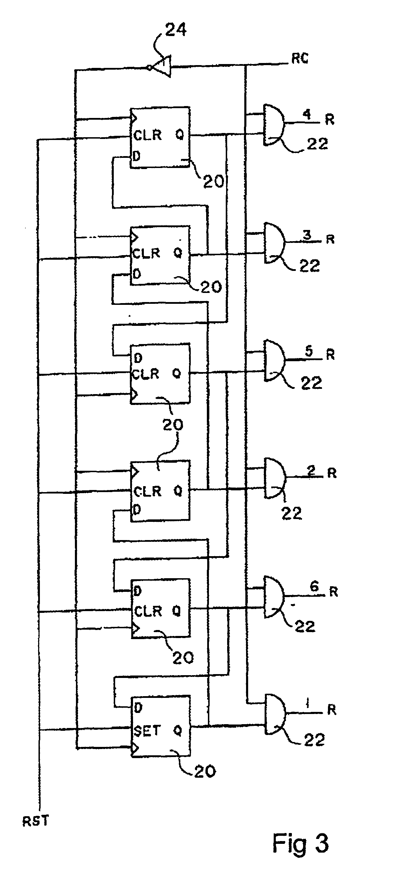

La figure 3 représente un mode de réalisation de circuit de commande des lignes d'écriture W et de lecture R permettant, à l'aide d'une mémoire à double accès, de réaliser une mémoire FIFO de structure particulièrement simple. La figure 3 illustre un exemple où l'on a six lignes de lecture R et six lignes d'écriture W. Un circuit du type de la figure 3 est associé aux six lignes de lecture R et un autre circuit identique est associé aux six lignes d'écriture W. On ne décrit ci-après que le circuit de commande associé aux lignes de lecture.

Ce circuit de commande comprend un registre à décalage à six bascules 20 disposées en cascade, c'est-à-dire que la sortie de chaque bascule est reliée à l'entrée de la bascule suivante. Chaque sortie d'une bascule 20 est fournie à l'une des lignes de lecture R par une porte ET 22. Une deuxième entrée des portes ET 22 est reliée à la ligne de lecture de colonne RC qui est également reliée aux entrées d'horloge des bascules 20 par l'intermédiaire d'un inverseur 24. Un signal d'initialisation RST est fourni à chacune des bascules 20. L'activation de ce signal RST met à "1" la première bascule 20 et toutes les autres à "0". Le registre à décalage est rebouclé, c'est-à-dire que la sortie de la dernière bascule est reliée à l'entrée de la première bascule. Comme cela est représenté, les bascules 20 sont disposées de manière entrelacée, c'est-à-dire que la bascule de dernier rang (6) est disposée entre les bascules de premier rang (1) et deuxième rang (2), que la bascule d'avant dernier rang (5) est disposée entre les bascules de deuxième rang (2) et troisième rang (3)... Avec cette disposition, les connexions entre les bascules sont toutes de sensiblement la même longueur, quel que soit le nombre de bascules, ce qui évite que les bascules aient des délais de commutation différents.

Initialement, par l'activation du signal RST, la bascule de rang 1 est à "1" et toutes les autres à "0". Quand la ligne RC est activée, la première rangée de cellules est sélectionnée en lecture. Lorsque la ligne RC est désactivée, le "1" qui était dans la première bascule 20 se propage dans la deuxième bascule. A la prochaine activation de la ligne RC, c'est la deuxième rangée de cellules qui est sélectionnée en lecture. Lorsque le "1" atteint la dernière bascule (6), il repasse dans la première bascule dès la désactivation suivante du signal RC.

Un circuit de commande identique à celui de la figure 3 est également associé aux lignes d'écriture W. Les lignes d'écriture W sont reliées aux sorties des portes ET 22 et la ligne d'écriture de colonne WC est reliée à l'entrée de l'inverseur 24. Bien entendu, les rangs des bascules peuvent être changés si l'on souhaite lire les données stockées dans un ordre différent de celui de leur écriture.

On obtient ainsi une structure de mémoire FIFO particulièrement simple car les rangées de cellules sont directement sélectionnées par les registres à décalage sans qu'il soit nécessaire d'utiliser un système complexe classique de génération d'adresses et de décodage de ces adresses.

Bien entendu, il faut que les dispositifs qui écrivent ou lisent dans la mémoire FIFO puissent connaître l'état de remplissage de celle-ci. Pour cela, ces dispositifs ont besoin d'un signal FULL indiquant que la mémoire est pleine et éventuellement d'un signal ½FULL indiquant que la mémoire est à moitié pleine.

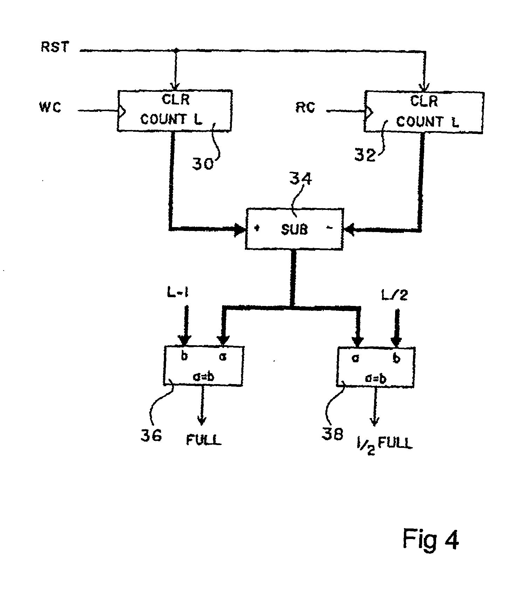

La figure 4 représente schématiquement un circuit permettant d'obtenir de tels signaux FULL et ½FULL.

Ce circuit comprend deux compteurs par L 30 et 32, L étant le nombre de rangées de cellules de la mémoire FIFO (6 dans l'exemple de la figure 3). Le compteur 30 est activé par la ligne d'écriture de colonne WC et le compteur 32 est activé par la ligne de lecture de colonne RC. Les deux compteurs 30 et 32 sont remis à zéro par le signal RST. Les sorties des compteurs 30 et 32 sont fournies à un soustracteur numérique 34 qui fournit la différence entre le contenu du compteur 30 et celui du compteur 32 (c'est-à-dire la différence entre le nombre de données écrites et le nombre de données lues). La sortie du soustracteur 34 est fournie à une entrée a de deux comparateurs 36 et 38. Une entrée b du comparateur 36 reçoit le nombre L-1 et une entrée b du comparateur 38 reçoit le nombre L/2. Le comparateur 36 fournit le signal d'état plein FULL lorsque le résultat de la soustraction dans le soustracteur 34 est égal à L-1 et le comparateur 38 active le signal d'état demi-plein ½FULL lorsque le résultat de la soustraction est égal à L/2.

De nombreuses variantes et modifications de la présente invention apparaîtront à l'homme du métier, notamment en ce qui concerne le choix des polarités des signaux et l'adaptation qui en résulte des différents circuits.

## Revendications

1. Mémoire de type premier-entré/premier-sorti comprenant :
- des cellules mémoire à double accès (10) disposées en colonnes ;
- une ligne de sortie (Bo) par colonne reliée à chaque cellule de la colonne par un transistor de lecture (M2) commandé par une ligne de lecture respective (R) ;
- une ligne d'entrée (Bi) par colonne reliée à chaque cellule (10) de la colonne par un transistor d'écriture (M1) commandé par une ligne d'écriture (W) respective ;
- un premier registre à décalage rebouclé dont les sorties commandent respectivement les lignes de lecture (R), le décalage de ce registre étant commandé par l'inverse d'un signal de sélection en lecture (RC) ; et
- un deuxième registre à décalage rebouclé dont les sorties commandent respectivement lesdites lignes d'écriture (W), le décalage de ce registre étant commandé par l'inverse d'un signal de sélection en écriture (WC) ;
**caractérisée en ce que** les premier et deuxième registres à décalage comprennent des bascules (20) connectées de manière entrelacée de sorte que les connexions entre les bascules sont toutes de sensiblement la même longueur.

2. Mémoire selon la revendication 1, **caractérisée en ce qu'**elle comprend :
- des premier et deuxième compteurs (30, 32) jusqu'au nombre (L) de rangées de cellules de la mémoire, validés respectivement par les signaux de sélection en écriture et en lecture (WC, RC) ;
- un soustracteur (34) fournissant la différence des contenus des premier et deuxième compteurs ; et
- un comparateur (36) activant un signal de mémoire pleine (FULL) si la différence est égale au nombre de rangées diminué de 1.

3. Mémoire selon la revendication 1, **caractérisée en ce qu'**elle comprend un comparateur (38) activant un signal de mémoire demi-pleine (½FULL) si la différence est égale à la moitié du nombre de rangées.

## Patentansprüche

1. Speicher vom FIFO-(first-in/first-out)-Typ, welcher umfaßt:
- in Spalten angeordnete Doppel-Zugang-bzw.Anschluß-Speicherzellen (10);
- je Spalte eine Ausgangsleitung (Bo), die jeweils mit jeder Zelle der Spalte über einen durch eine entsprechende Leseleitung (R) gesteuerten Lese-Transistor (M2) verbunden ist;
- je Spalte eine Eingangsleitung (Bi), die jeweils mit jeder Zelle (10) der Spalte über einen durch eine entsprechende Schreib-Leitung (W) gesteuerten Schreib-Transistor (M1) verbunden ist;
- ein erstes Ring-Schieberegister, dessen Ausgänge jeweils entsprechend die Leseleitungen (R) steuern, wobei die Verschiebung bzw. Versetzung dieses Registers durch das Komplement bzw. die Inversion eines Lese-Wählsignals (RC) gesteuert wird;
- ein zweites Ring-Schieberegister, dessen Ausgänge jeweils entsprechend die genannten Schreibleitungen (W) steuern, wobei die Verschiebung bzw. Versetzung dieses Registers durch das Komplement bzw. die Inversion eines Schreib-Wählsignals (WC) gesteuert wird;
**dadurch gekennzeichnet, daß**
die ersten und zweiten Schieberegister Kippschaltungen (20) umfassen, die so miteinander verschachtelt angeschlossen sind, daß die Verbindungen zwischen den Kippschaltungen sämtlich im wesentlichen die gleiche Länge besitzen.

2. Speicher nach Anspruch 1, **dadurch gekennzeichnet, daß** er umfaßt:
- erste und zweite Zähler (30, 32) bis zur Anzahl (L) der Reihen bzw. Zeilen von Zellen des Speichers, die jeweils durch die Schreib-Wählsignale bzw. Lese-Wählsignale (WC, RC) aktiviert werden;
- eine Substraktionsvorrichtung (34) zur Bildung der Differenz der Zählinhalte der ersten und zweiten Zähler;
- einen Komparator (36), welcher ein Signal Speicher-Voll (FULL) aktiviert, wenn die Differenz gleich der um 1 verminderten Zahl der Reihen bzw. Zeilen beträgt.

3. Speicher nach Anspruch 2, **dadurch gekennzeichnet, daß** der Speicher einen Komparator (38) aufweist, welcher ein Signal Speicher-Halbvoll (1/2FULL) aktiviert, wenn die Differenz gleich der Hälfte der Anzahl der Reihen bzw. Zeilen beträgt.

## Claims

1. A first-in/first-out memory including:
- dual-port memory cells (10) disposed in columns;
- one input line (Bo) per column connected to each cell of the column by a read transistor (M2) that is controlled by a respective read line (R);
- one input line (Bi) per column connected to each cell (10) of the column through a write transistor (M1) that is turned on by a respective write line (W);
- a first circular shift register whose outputs respectively control the read lines (R), the shifting of said register being controlled by the complement of a read selection signal (RC); and
- a second circular shift register whose outputs respectively control said write lines (W), the shifting of said register being controlled by the complement of a write selection signal (WC);
**characterized in that** the first and second shift registers include interleaved flip-flops so that all the connections between the flip-flops have substantially the same length.

2. The memory of claim 1, **characterized in that** it comprises:
- first and second counters (30, 32) up to the number (L) of rows of cells in the memory, enabled respectively by the write and read selection signals (WC, RC) ;
- a subtractor (34) providing the difference of the contents of the first and second counters; and
- a comparator (36) asserting a full memory signal (FULL) if said difference is equal to the number of rows minus 1.

3. The memory of claim 1, **characterized in that** it comprises a comparator (38) asserting a half-full memory signal (1/2FULL) if said difference is equal to half the number of rows.
